# EUROPEAN PATENT APPLICATION

(11) **EP 4 741 529 A1**
(43) Date of publication of application: **13.05.2026**
(21) Application number: 25205453.1
(22) Date of filing: 29.09.2025
(51) Int. Cl.: C23C 16/455, C23C 16/34

(54) **SUBSTRATE PROCESSING METHOD, METHOD OF MANUFACTURING SEMICONDUCTOR DEVICE, PROGRAM AND SUBSTRATE PROCESSING APPARATUS**

(30) Priority: 18.10.2024 JP 2024184215; 03.09.2025 JP 2025146072
(71) Applicant: Kokusai Electric Corp., Tokyo 1010045 (JP)
(72) Inventor: MATSUNO, Yutaka, Toyama-shi, 939-2393 (JP)
(74) Representative: Verscht, Thomas Kurt Albert

(57) **Abstract**

It is possible to improve a film forming rate. There is provided a technique that includes: (a) supplying a first gas containing a primary element constituting a film and a halogen element to a substrate; (b) supplying a first reducing gas containing hydrogen to the substrate; (c) supplying a second reducing gas containing hydrogen to the substrate, wherein a material of the second reducing gas is different from that of the first reducing gas; (d) performing (a) and (b) in parallel, wherein a supply amount of the first reducing gas is decreased compared to that of when a supply of the first reducing gas is started while performing (a) and (b) in parallel; and (e) performing (d) and (c) a predetermined number of times to form the film on the substrate.

## Description

### [Technical Field]

The present disclosure relates to a substrate processing method, a method of manufacturing a semiconductor device, a program and a substrate processing apparatus

### [Related Art]

As a part of a manufacturing process of a semiconductor device, a step of forming a film on a surface of a substrate may be performed (for example, see Patent Document 1).

### [Related Art Document]

### [Patent Document]

Patent Document 1: Japanese Patent Laid-Open No. 2011-006783

### [Disclosure]

### [Technical Problem]

In a step of forming a film, a film forming speed (film forming rate) may decrease.

According to the present disclosure, there is provided a technique capable of improving the film forming rate.

### [Technical Solution]

According to an embodiment of the present disclosure, there is provided a technique that includes: (a) supplying a first gas containing a primary element constituting a film and a halogen element to a substrate; (b) supplying a first reducing gas containing hydrogen to the substrate; (c) supplying a second reducing gas containing hydrogen to the substrate, wherein a material of the second reducing gas is different from that of the first reducing gas; (d) performing (a) and (b) in parallel, wherein a supply amount of the first reducing gas is decreased compared to that of when a supply of the first reducing gas is started while performing (a) and (b) in parallel; and (e) performing (d) and (c) a predetermined number of times to form the film on the substrate.

### [Advantageous Effects]

According to some embodiments of the present disclosure, it is possible to improve a film forming rate.

### [Brief Description of Drawings]

FIG. 1 is a diagram schematically illustrating a vertical cross-section of a substrate processing apparatus according to one or more embodiments of the present disclosure.
FIG. 2 is a diagram schematically illustrating a horizontal cross-section taken along a line A - A of the substrate processing apparatus shown in FIG. 1.
FIG. 3 is a block diagram schematically illustrating a configuration of a controller and its related components of the substrate processing apparatus.
FIG. 4 is a flow chart schematically illustrating a series of steps including a substrate processing step.
FIG. 5 is a diagram schematically illustrating gas supply timings in the substrate processing step.
FIG. 6 is a diagram schematically illustrating patterns of supplying a first gas and a second gas.
FIG. 7 is a diagram schematically illustrating patterns of supplying the first gas and the second gas.
FIG. 8 is a diagram schematically illustrating patterns of supplying the first gas and the second gas.
FIG. 9 is a diagram schematically illustrating patterns of supplying the first gas and the second gas.
FIG. 10 is a diagram schematically illustrating an example of table data indicating a relationship between a process temperature and a reduction rate of the second gas.

### [Detailed Description]

### <Embodiments>

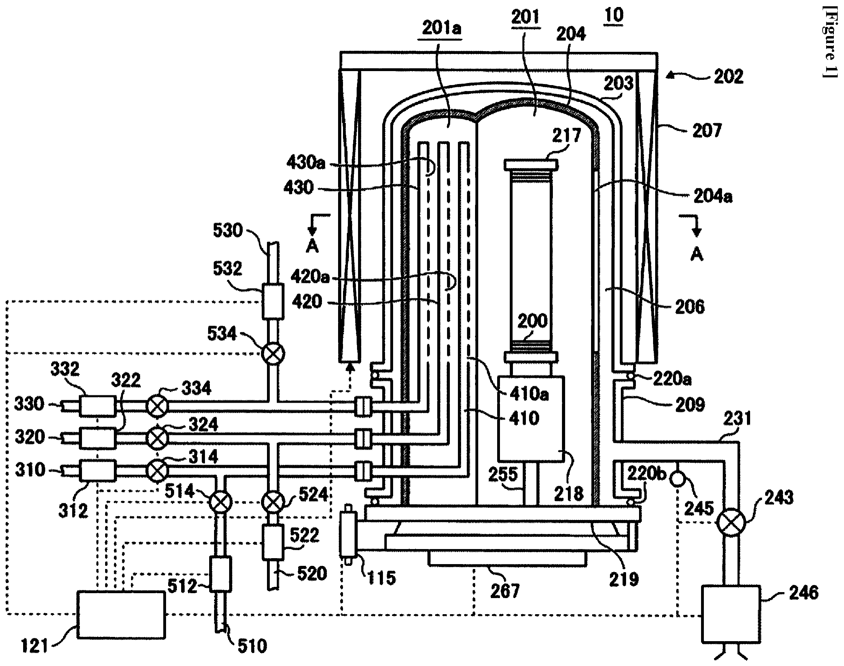

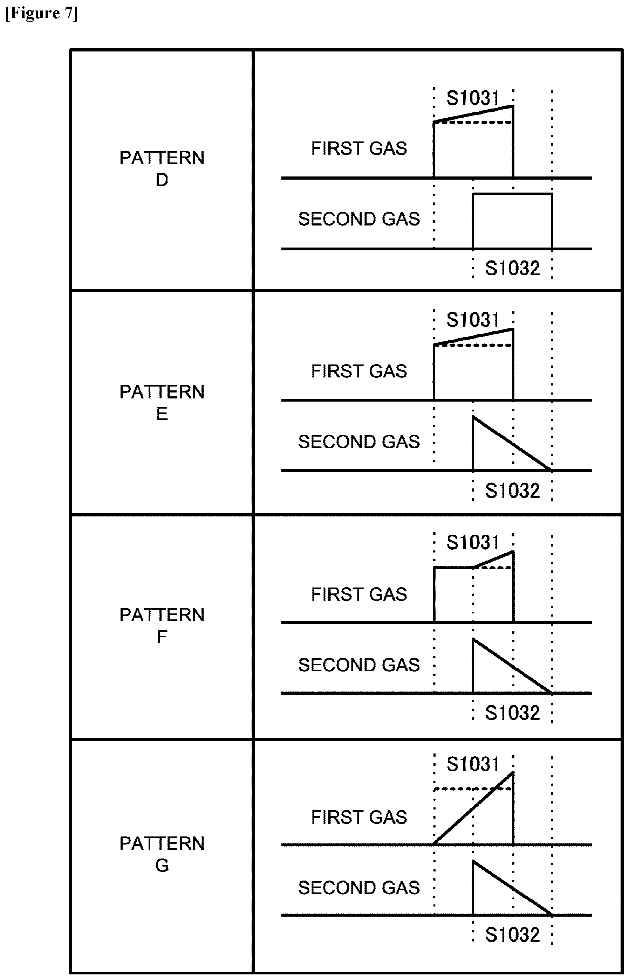

Hereinafter, one or more embodiments (hereinafter, also simply referred to as "embodiments") according to the present disclosure will be described with reference to FIGS. 1 to 10. For example, the drawings used in the following descriptions are all schematic, and a relationship between dimensions of each component and a ratio of each component shown in the drawing may not always match the actual ones. In addition, even between the drawings, the relationship between the dimensions of each component and the ratio of each component may not always match.

### (1) Configuration of Substrate Processing Apparatus

A substrate processing apparatus 10 according to the present embodiments includes a process furnace 202 provided with a heater 207 serving as a heating structure (which is a heating apparatus or a heating system). The heater 207 is of a cylindrical shape, and is vertically installed while being supported by a heater base (not shown) serving as a support plate.

An outer tube 203 constituting a process vessel is provided in an inner side of the heater 207 to be aligned in a manner concentric with the heater 207. For example, the outer tube 203 is made of a heat resistant material such as quartz and silicon carbide (SiC). For example, the outer tube 203 is of a cylindrical shape with a closed upper end and an open lower end. A manifold 209 (hereinafter, also referred to as an "MF 209") is provided under the outer tube 203 to be aligned in a manner concentric with the outer tube 203. For example, the MF 209 is made of a metal such as stainless steel. For example, the MF 209 is of a cylindrical shape with open upper and lower ends. An O-ring 220a serving as a seal is provided between an upper end portion of the MF 209 and the outer tube 203. As the MF 209 is supported by the heater base, the outer tube 203 is installed vertically.

An inner tube 204 constituting the process vessel is provided in an inner side of the outer tube 203. For example, the inner tube 204 is made of a heat resistant material such as quartz and silicon carbide (SiC). For example, the inner tube 204 is of a cylindrical shape with a closed upper end and an open lower end. The process vessel is constituted mainly by the outer tube 203, the inner tube 204 and the MF 209. A process chamber 201 is provided in a hollow cylindrical portion of the process vessel (that is, an inside (inner portion) of the inner tube 204).

The process chamber 201 is configured to be capable of accommodating a plurality of wafers 200 in a horizontal orientation to be vertically arranged in a multistage manner by a boat 217 described later. Hereinafter, each of the plurality of wafers 200 may also be simply referred to as a "wafer 200" serving as a substrate.

Nozzles 410, 420 and 430 are installed in the process chamber 201 so as to penetrate a side wall of the MF 209 and the inner tube 204. Gas supply pipes 310, 320 and 330 are connected to the nozzles 410, 420 and 430, respectively.

Mass flow controllers (also simply referred to as "MFCs") 312, 322 and 332 serving as flow rate controllers (flow rate control structures) and valves 314, 324 and 334 serving as opening/closing valves are sequentially installed at the gas supply pipes 310, 320 and 330, respectively, in this order from upstream sides to downstream sides of the gas supply pipes 310, 320 and 330 in a gas flow direction. Gas supply pipes 510, 520 and 530 through which an inert gas is supplied are connected to the gas supply pipes 310, 320 and 330, respectively, at downstream sides of the valves 314, 324 and 334. MFCs 512, 522 and 532 serving as flow rate controllers (flow rate control structures) and valves 514, 524 and 534 serving as opening/closing valves are sequentially installed at the gas supply pipes 510, 520 and 530, respectively, in this order from upstream sides to downstream sides of the gas supply pipes 510, 520 and 530 in the gas flow direction.

The nozzles 410, 420 and 430 are connected to front ends (tips) of the gas supply pipes 310, 320 and 330, respectively. Each of the nozzles 410, 420 and 430 may be configured as an L-shaped nozzle. Horizontal portions of the nozzles 410, 420 and 430 are installed so as to penetrate the side wall of the MF 209 and the inner tube 204. Vertical portions of the nozzles 410, 420 and 430 are installed in a preliminary chamber 201a of a channel shape (a groove shape) protruding outward in a radial direction of the inner tube 204 and extending in the vertical direction. That is, the vertical portions of the nozzles 410, 420 and 430 are installed in the preliminary chamber 201a to extend upward (in a direction in which the wafers 200 are arranged) along an inner wall of the inner tube 204.

The nozzles 410, 420 and 430 extend from a lower region of the process chamber 201 to an upper region of the process chamber 201. The nozzles 410, 420 and 430 are provided with a plurality of gas supply holes 410a, a plurality of gas supply holes 420a and a plurality of gas supply holes 430a, respectively, at positions facing the wafers 200. Thereby, process gases can be supplied to the wafers 200 through the gas supply holes 410a of the nozzle 410, the gas supply holes 420a of the nozzle 420 and the gas supply holes 430a of the nozzle 430, respectively. The gas supply holes 410a, the gas supply holes 420a and the gas supply holes 430a are provided from a lower portion to an upper portion of the inner tube 204. An opening area of each of the gas supply holes 410a, the gas supply holes 420a and the gas supply holes 430a is the same, and each of the gas supply holes 410a, the gas supply holes 420a and the gas supply holes 430a is provided at the same pitch.

The gas supply holes 410a of the nozzle 410, the gas supply holes 420a of the nozzle 420 and the gas supply holes 430a of the nozzle 430 are provided within a height range from a lower portion to an upper portion of the boat 217 described later. Therefore, the process gases supplied into the process chamber 201 through the gas supply holes 410a, the gas supply holes 420a and the gas supply holes 430a are supplied onto the wafers 200 accommodated in the boat 217 from the lower portion to the upper portion thereof, that is, an entirety of the wafers 200 accommodated in the boat 217. It is preferable that the nozzles 410, 420 and 430 extend from the lower region to the upper region of the process chamber 201. However, the nozzles 410, 420 and 430 may preferably extend only to the vicinity of a ceiling of the boat 217.

As a first material (which is a source material), a first element-containing gas (hereinafter, also referred to as a "first gas") containing a first element is supplied into the process chamber 201 through the gas supply pipe 310 provided with the MFC 312 and the valve 314 and the nozzle 410. The first gas serves as one of the process gases. As the first gas, for example, a gas containing the first element (primary element) and a halogen element may be used.

As a first reactant (which is a reacting agent), a second gas is supplied into the process chamber 201 through the gas supply pipe 320 provided with the MFC 322 and the valve 324 and the nozzle 420. The second gas serves as one of the process gases. In the present specification, the term "agent" may contain at least one selected from the group of a gaseous substance and a liquid substance. The liquid substance may contain a mist substance. That is, an agent such as the reacting agent, a film forming agent, a modifying agent and an etching agent may contain a gaseous substance, may contain a liquid substance such as a mist substance, or may contain both of the gaseous substance and the liquid substance.

As a second reactant (which is another reacting agent), a third gas is supplied into the process chamber 201 through the gas supply pipe 330 provided with the MFC 332 and the valve 334 and the nozzle 430. The third gas serves as one of the process gases.

As the inert gas, for example, nitrogen (N₂) gas is supplied into the process chamber 201 through the gas supply pipes 510, 520 and 530 provided with the MFCs 512, 522 and 532 and the valves 514, 524 and 534, respectively, and the nozzles 410, 420 and 430. Hereinafter, the present embodiments will be described by way of an example in which the N₂ gas is used as the inert gas. However, as the inert gas, for example, instead of or in addition to the N₂ gas, a rare gas such as argon (Ar) gas, helium (He) gas, neon (Ne) gas and xenon (Xe) gas may be used.

A gas supplier (which is a gas supply system) is constituted mainly by the gas supply pipes 310, 320 and 330, the MFCs 312, 322 and 332, the valves 314, 324 and 334 and the nozzles 410, 420 and 430. However, the gas supplier may be constituted by the nozzles 410, 420 and 430 without including other components mentioned above. The gas supplier may also be referred to as a "process gas supplier" which is a process gas supply system. In addition, an inert gas supplier (which is an inert gas supply system) is constituted mainly by the gas supply pipes 510, 520 and 530, the MFCs 512, 522 and 532 and the valves 514, 524 and 534.

When the first gas is supplied through the gas supply pipe 310, a first gas supplier (which is a first gas supply system) is constituted mainly by the gas supply pipe 310, the MFC 312 and the valve 314. For example, the first gas supplier may further include the nozzle 410. In addition, when the second gas is supplied through the gas supply pipe 320, a second gas supplier (which is a second gas supply system) is constituted mainly by the gas supply pipe 320, the MFC 322 and the valve 324. For example, the second gas supplier may further include the nozzle 420. In addition, when the third gas is supplied through the gas supply pipe 330, a third gas supplier (which is a third gas supply system) is constituted mainly by the gas supply pipe 330, the MFC 332 and the valve 334. For example, the third gas supplier may further include the nozzle 430.

According to the present embodiments, gases such as the process gases are supplied into a vertically long annular space (which is defined by the inner wall of the inner tube 204 and edges (peripheries) of the wafers 200) through the nozzles 410, 420 and 430 provided in the preliminary chamber 201a. Then, the gases are ejected into the inner tube 204 through the gas supply holes 410a of the nozzle 410, the gas supply holes 420a of the nozzle 420 and the gas supply holes 430a of the nozzle 430, respectively, at the positions facing the wafers 200. More specifically, the gases such as the process gases are ejected into the inner tube 204 in a direction parallel to surfaces of the wafers 200 through the gas supply holes 410a of the nozzle 410, the gas supply holes 420a of the nozzle 420 and the gas supply holes 430a of the nozzle 430, respectively.

An exhaust hole (which is an exhaust port) 204a is a through-hole facing the nozzles 410, 420 and 430, and is provided at a side wall of the inner tube 204. For example, the exhaust hole 204a may be of a narrow slit-shaped through-hole elongating vertically. The gas supplied into the process chamber 201 through the gas supply holes 410a of the nozzle 410, the gas supply holes 420a of the nozzle 420 or the gas supply holes 430a of the nozzle 430 flows over the surfaces of the wafers 200. The gases that flowed over the surfaces of the wafers 200 are exhausted through the exhaust hole 204a into an exhaust path 206 (which is constituted by a gap provided between the inner tube 204 and the outer tube 203). The gases flowing in the exhaust path 206 flow into an exhaust pipe 231 and are then discharged (exhausted) out of the process furnace 202.

The exhaust hole 204a is provided to face the wafers 200. The gas supplied to the vicinity of the wafers 200 in the process chamber 201 through the gas supply holes 410a, the gas supply holes 420a or the gas supply holes 430a flows in the horizontal direction. The gases that flowed in the horizontal direction are exhausted through the exhaust hole 204a into the exhaust path 206. The exhaust hole 204a is not limited to the slit-shaped through-hole. For example, the exhaust hole 204a may be configured as a plurality of holes.

The exhaust pipe 231 through which an atmosphere (inner atmosphere) of the process chamber 201 is exhausted is installed at the MF 209. A pressure sensor 245 serving as a pressure detector (pressure detecting structure) configured to detect a pressure (inner pressure) of the process chamber 201, an APC (Automatic Pressure Controller) valve 243 and a pump (vacuum pump) 246 serving as an exhaust apparatus are sequentially connected to the exhaust pipe 231 in this order from an upstream side to a downstream side of the exhaust pipe 231 in the gas flow direction. With the pump 246 in operation, the APC valve 243 may be opened or closed to perform an exhaust of the process chamber 201 or stop the exhaust. In addition, with the pump 246 in operation, an opening degree of the APC valve 243 may be adjusted in order to adjust the inner pressure of the process chamber 201. An exhauster (which is an exhaust system) is constituted mainly by the exhaust hole 204a, the exhaust path 206, the exhaust pipe 231, the APC valve 243 and the pressure sensor 245. The exhauster may further include the pump 246.

A seal cap 219 (hereinafter, also referred to as an "SC 219") serving as a furnace opening lid capable of airtightly sealing (closing) a lower end opening of the MF 209 is provided under the MF 209. The SC 219 is in contact with the lower end of the MF 209 from thereunder. For example, the SC 219 is made of a metal such as SUS, and is of a disk shape. An O-ring 220b serving as a seal is provided on an upper surface of the SC 219 so as to be in contact with the lower end of the MF 209. A rotator (which is a rotating structure) 267 configured to rotate the boat 217 accommodating the wafers 200 is provided at the SC 219 in a manner opposite to the process chamber 201. A rotating shaft 255 of the rotator 267 is connected to the boat 217 through the SC 219. The rotator 267 is configured to rotate the wafers 200 by rotating the boat 217. The SC 219 is configured to be elevated or lowered in the vertical direction by a boat elevator 115 (hereinafter, also referred to as a "BE 115") serving as an elevating structure vertically provided outside the outer tube 203. By elevating and lowering the SC 219 in the vertical direction, the BE 115 is configured to be capable of transferring (loading) the boat 217 into the process chamber 201 and capable of transferring (unloading) the boat 217 out of the process chamber 201. The BE 115 serves as a transfer structure (transfer system) that loads the boat 217 and the wafers 200 accommodated in the boat 217 into the process chamber 201 and that unloads the boat 217 and the wafers 200 accommodated in the boat 217 out of the process chamber 201.

The boat 217 serving as a substrate support is configured to accommodate (or support) the wafers 200 (for example, from 10 wafers to 200 wafers) while the wafers 200 are horizontally oriented with their centers aligned with one another with a predetermined interval therebetween in the vertical direction. In the present specification, a notation of a numerical range such as "from 10 wafers to 200 wafers" means that a lower limit and an upper limit thereof are included in the numerical range. Therefore, for example, the numerical range "from 10 wafers to 200 wafers" means a range equal to or higher than 10 wafers and equal to or lower than 200 wafers. The same also applies to other numerical ranges described herein.

For example, the boat 217 is made of a heat resistant material such as quartz and SiC. For example, a lower portion of the boat 217 is supported by a plurality of heat insulating plates 218 made of a heat resistant material such as quartz and SiC. The plurality of heat insulating plates 218 are horizontally oriented with their centers aligned with one another in the vertical direction.

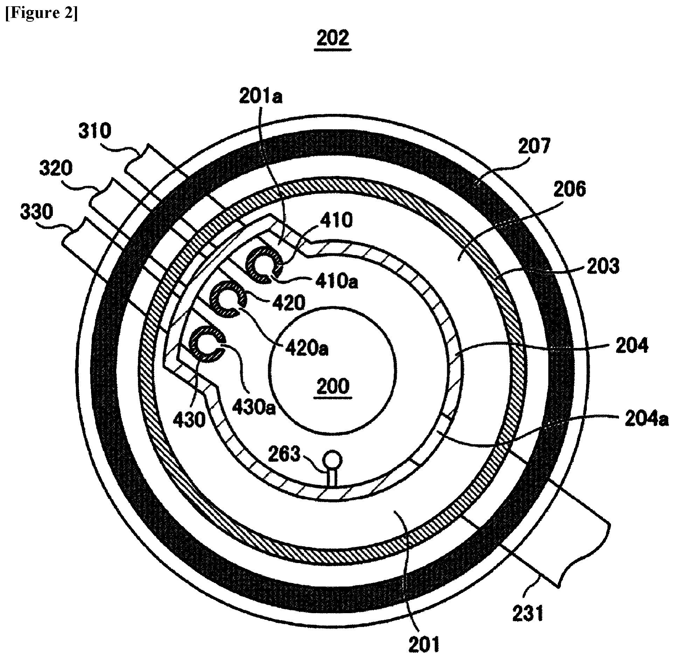

As shown in FIG. 2, a temperature sensor 263 serving as a temperature detector is installed in the inner tube 204. An amount of the electric current supplied (or applied) to the heater 207 is adjusted based on temperature information detected by the temperature sensor 263 such that a desired temperature distribution of a temperature (inner temperature) of the process chamber 201 can be obtained. Similar to the nozzles 410, 420 and 430, the temperature sensor is L-shaped, and is provided along the inner wall of the inner tube 204.

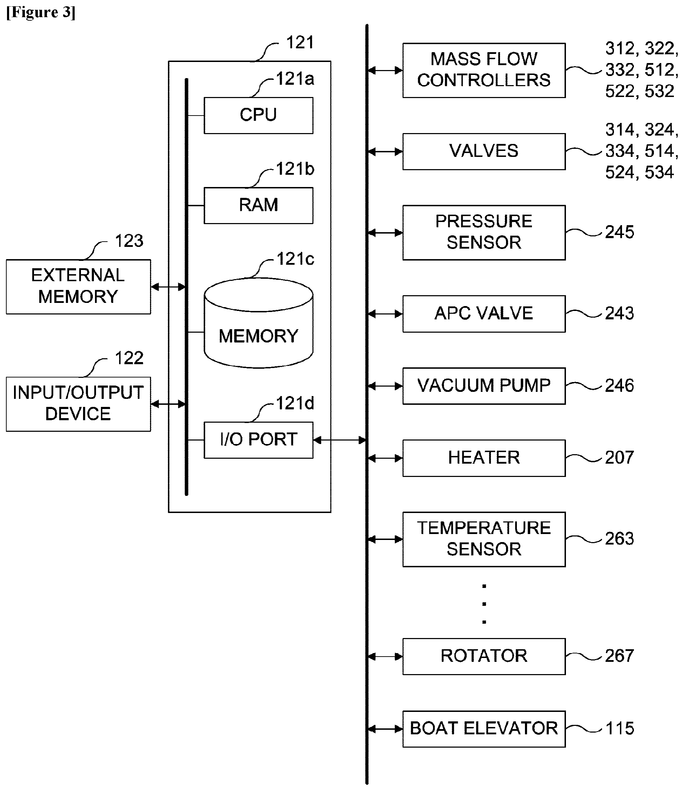

As shown in FIG. 3, a controller 121 serving as a control structure (or a control apparatus) is constituted by a computer including a CPU (Central Processing Unit) 121a, a RAM (Random Access Memory) 121b, a memory 121c and an I/O port (input/output port) 121d. The RAM 121b, the memory 121c and the I/O port 121d are configured to be capable of exchanging data with the CPU 121a through an internal bus. For example, an input/output device 122 constituted by a component such as a touch panel is connected to the controller 121. In addition, the controller 121 is configured such that an external memory 123 can be connected to the controller 121. For example, the external memory 123 may include one or more among a magnetic disk such as a hard disk, an optical disk such as a CD and a DVD, a magneto-optical disk such as an MO and a semiconductor memory such as a USB memory and a memory card.

For example, as the control structure, the substrate processing apparatus 10 may include a single control structure, or include a plurality of control structures. That is, a control operation of performing a substrate processing described later may be performed using the single control structure, or may be performed using the plurality of control structures. In addition, the plurality of control structures may be configured as a control system that are connected to one another via a wired or wireless communication network, and an entirety of the control system may perform the control operation of performing the substrate processing described below. Thus, in the present specification, the term "control structure" may refer to the single control structure, may refer to the plurality of control structures, or may refer to the control system configured by the plurality of control structures.

For example, the memory 121c is configured by a component such as a flash memory and a hard disk drive (HDD). For example, a control program configured to control an operation of the substrate processing apparatus 10, a process recipe containing information on procedures and conditions of a method of manufacturing a semiconductor device described later, or table data showing a relationship between a process temperature and an amount of reduction of the second gas (first reducing gas) may be readably stored in the memory 121c. The process recipe is obtained by combining steps (procedures) of the method of manufacturing a semiconductor device described later such that the controller 121 can execute the steps to acquire a predetermined result, and functions as a program. Hereinafter, the process recipe and the control program may be collectively or individually referred to as a "program". Thus, in the present specification, the term "program" may refer to the process recipe alone, may refer to the control program alone or may refer to a combination of the process recipe and the control program. The RAM 121b functions as a memory area (work area) where a program or data read by the CPU 121a is temporarily stored.

The I/O port 121d is connected to components described above such as the MFCs 312, 322, 332, 512, 522 and 532, the valves 314, 324, 334, 514, 524 and 534, the pressure sensor 245, the APC valve 243, the vacuum pump 246, the heater 207, the temperature sensor 263, the rotator 267 and the BE 115.

The CPU 121a is configured to be capable of reading the control program from the memory 121c and executing the control program read from the memory 121c. In addition, the CPU 121a is further configured to be capable of reading the process recipe from the memory 121c, for example, in accordance with an operation command inputted from the input/output device 122. In accordance with contents of the process recipe read from the memory 121c, the CPU 121a may be configured to be capable of controlling various operations such as flow rate adjusting operations for various gases by the MFCs 312, 322, 332, 512, 522 and 532, opening and closing operations of the valves 314, 324, 334, 514, 524 and 534, an opening and closing operation of the APC valve 243, a pressure adjusting operation by the APC valve 243 based on the pressure sensor 245, a start and stop operation of the vacuum pump 246, a temperature adjusting operation by the heater 207 based on the temperature sensor 263, an operation of adjusting a rotation and a rotation speed of the boat 217 by the rotator 267, an elevating and lowering operation of the boat 217 by the BE 115 and an operation of accommodating the wafer 200 into the boat 217.

The controller 121 may be embodied by installing the above-described program stored in the external memory 123 into the computer. As described above, for example, the external memory 123 may include one or more among the magnetic disk such as the hard disk, the optical disk such as the CD and the DVD and the semiconductor memory such as a flash memory. The memory 121c or the external memory 123 may be embodied by a non-transitory computer readable recording medium. Hereafter, the memory 121c and the external memory 123 may be collectively or individually referred to as a "recording medium". Thus, in the present specification, the term "recording medium" may refer to the memory 121c alone, may refer to the external memory 123 alone, or may refer to both of the memory 121c and the external memory 123. Instead of the external memory 123, a communication interface such as the Internet and a dedicated line may be used for providing the program (program product) to the computer.

### (2) Substrate Processing (Film Forming Step)

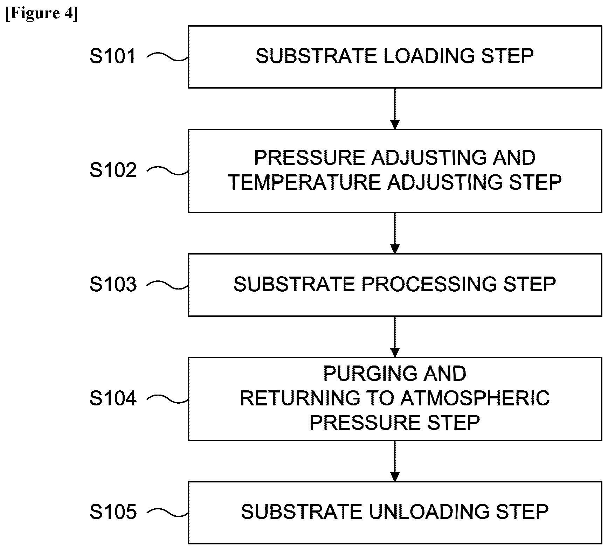

Hereinafter, an example of the substrate processing (film forming step) of forming a film on the wafer 200, which is a part of a manufacturing process of the semiconductor device, will be described mainly with reference to FIGS. 4 to 10. The film forming step is performed by using the substrate processing apparatus 10 described above. In the following description, operations of components constituting the substrate processing apparatus 10 are controlled by the controller 121.

The substrate processing (that is, the manufacturing process of the semiconductor device) according to the present embodiments may include:
(a) supplying the first gas containing the primary element constituting the film and the halogen element to the wafer 200;
(b) supplying the first reducing gas (that is, the second gas) containing hydrogen to the wafer 200;
(c) supplying the second reducing gas (that is, the third gas) containing hydrogen to the wafer 200, wherein a material of the second reducing gas is different from that of the first reducing gas;
(d) performing (a) and (b) in parallel, wherein a supply amount of the first reducing gas is decreased compared to that of when a supply of the first reducing gas is started while (a) and (b) are performed in parallel; and
(e) performing (d) and (c) a predetermined number of times to form the film on the wafer 200.

In the present specification, the term "wafer" may refer to "a wafer itself", or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself", or may refer to "a surface of a predetermined layer (or a predetermined film) formed on a wafer". In the present specification, the terms "substrate" and "wafer" may be used as substantially the same meaning.

### <Wafer Loading Step (Substrate Loading Step): S101>

The wafers 200 are charged (loaded or transferred) into the boat 217. Then, as shown in FIG. 1, the boat 217 supporting the wafers 200 is elevated by the BE 115 and loaded (transferred) into the process chamber 201 of the process vessel such that the boat 217 is accommodated in the process vessel.

### <Pressure Adjusting and Temperature Adjusting Step: S102>

Then, the pump 246 exhausts the inner atmosphere of the process chamber 201 (that is, a space in which the wafers 200 are present (accommodated)) such that the inner pressure of the process chamber 201 reaches and is maintained at a desired pressure. In such an operation, the inner pressure of the process chamber 201 is measured by the pressure sensor 245, and the APC valve 243 is feedback-controlled based on pressure information measured by the pressure sensor 245 (pressure adjusting). The pump 246 continuously exhausts the inner atmosphere of the process chamber 201 until at least a processing of the wafer 200 is completed. In addition, the heater 207 heats the process chamber 201 such that the inner temperature of the process chamber 201 reaches and is maintained at a desired process temperature. In such an operation, the amount of the electric current supplied to the heater 207 is feedback-controlled based on the temperature information detected by the temperature sensor 263 such that the desired temperature distribution of the inner temperature of the process chamber 201 can be obtained (temperature adjusting). The heater 207 continuously heats the process chamber 201 until at least the processing of the wafer 200 is completed. In the present step, a temperature of the heater 207 is set to a temperature such that a temperature of the wafer 200 can be to a temperature within a range from 200°C to 650 °C, for example.

### <Substrate Processing Step: S103>

As the substrate processing step S103, steps S1031 to S1036 are performed.

### <First Gas Supply Step: S1031>

The valve 314 is opened to supply the first gas into the gas supply pipe 310. After a flow rate of the first gas is adjusted by the MFC 312, the first gas whose flow rate is adjusted is supplied into the process chamber 201 through the gas supply holes 410a of the nozzle 410, and is exhausted through the exhaust pipe 231.

In the present step, for example, the APC valve 243 is appropriately adjusted such that the inner pressure of the process chamber 201 can be set to a pressure within a range from 1 Pa to 3,990 Pa. For example, a supply flow rate of the first gas controlled by the MFC 312 can be set to a flow rate within a range from 0.01 slm to 3 slm. In the present specification, a notation of a numerical range such as "from 1 Pa to 3,990 Pa" means that a lower limit and an upper limit thereof are included in the numerical range. Therefore, for example, the numerical range "from 1 Pa to 3,990 Pa" means a range equal to or higher than 1 Pa and equal to or lower than 3,990 Pa. The same also applies to other numerical ranges described herein.

In the present step, the first gas is supplied to the wafer 200. By supplying the first gas to the wafer 200, a material containing the first element is adsorbed onto the wafer 200 (that is, on a base film (underlying film) formed on the surface of the wafer 200). As the first element, for example, one or more among titanium (Ti), zirconium (Zr), hafnium (Hf), molybdenum (Mo), ruthenium (Ru), aluminum (Al), gallium (Ga), silicon (Si), germanium (Ge), niobium (Nb), manganese (Mn), nickel (Ni), cobalt (Co) and yttrium (Y) may be used. As the source material, for example, a gas containing the first element and a halogen element may be used. As the halogen element is, for example, one or more among chlorine (Cl), fluorine (F) and bromine (Br) may be used. As the gas containing the first element and the halogen element, for example, one or more among WCl₆, WF₆, TiF₄, MoCl₅, MoF₅, MoO₂Cl₂, RuCl₃, RuF₃, HfCl₄, HfF₄, ZrCl₄, ZrF₄, AlCl₃, AlF₃, SiH₃Cl, SiH₂Cl₂, Si₂Cl₆, SiCl₄, TaCl₅, TaF₅, WCl₆, CoCl₂, CoF₂, YCl₃, YF₃, NbF₃, NbCl₃, MnF₂, MnCl₂, NiF₂, NiCl₂ and SiCl₄ may be used. Preferably, the source material contains chlorine as the halogen element. Hereinafter, the present embodiments will be described by way of an example in which the TiCl₄ is used as the source material. When the TiCl₄ is used as the source material of the first gas, TiClₓ (X is an integer of 4 or less) is adsorbed onto the wafer 200 (that is, on the base film base film formed on the surface of the wafer 200) by supplying the TiCl₄ gas. Thereby, a titanium-containing layer is formed.

### <Second Gas Supply Step: S1032>

Subsequently, the second gas supply step S1032 will be described. In the second gas supply step S1032, there is provided a period (time duration) during which the first gas supply step S1031 and the second gas supply step S1032 are performed in parallel.

The valve 324 is opened to supply the second gas into the gas supply pipe 320. After a flow rate of the second gas is adjusted by the MFC 322, the second gas whose flow rate is adjusted is supplied into the process chamber 201 through the gas supply holes 420a of the nozzle 420, and is exhausted through the exhaust pipe 231.

In the present step, for example, the APC valve 243 is appropriately adjusted such that the inner pressure of the process chamber 201 can be set to a pressure within a range from 1 Pa to 3,990 Pa. For example, a supply flow rate of the second gas controlled by the MFC 322 can be set to a flow rate within a range from 0.1 slm to 10 slm. For example, the time duration during which the first gas and the second gas are supplied to the wafer 200 in parallel can be set to a time duration within a range from 0.01 second to 70 seconds.

In such a time duration of the present step, the first gas and the second gas are supplied to the wafer 200. That is, in the present step, there is provided a timing at which at least the first gas and the second gas are supplied simultaneously. As the second gas, a reducing gas may be used. As the reducing gas serving as the second gas, a gas different from the third gas described later may be used. The second gas may also be referred to as a "first reducing gas". As the second gas, for example, a gas containing a predetermined element and hydrogen may be used. As the predetermined element, for example, one or more among Group 13 elements and Group 14 elements of the periodic table may be used. Specific examples of such a gas may include a silane-based gas such as SiH₄, Si₂H₆ and Si₃H₈ or a borane-based gas such as BH₃ and B₂H₆. Such a gas may also be referred to as a "hydride" of the predetermined element. Hereinafter, the present embodiments will be described by way of an example in which the SiH4 is used as the second gas.

By supplying the second gas in a manner described above, for example, it is possible to remove by-products (which serve as an adsorption inhibitor (adsorption-inhibiting material) that inhibits a film formation) such as hydrogen chloride (HCl). It is also possible to remove the by-products such as the HCl adsorbed in an area (region) where the by-products have not been adsorbed before the second gas is supplied. Thereby, it is possible to provide an adsorption site on the wafer 200 where the source material can be adsorbed. That is, it is possible to form the adsorption site on the surface of the wafer 200 where the source material such as TiClₓ can be adsorbed. In the present embodiments, the term "adsorption site where the source material can be adsorbed" may refer to an area on the wafer 200 where the by-products are not adsorbed.

### <Stopping Supply of First Gas and Continuing Supply of Second Gas>

After a predetermined time has elapsed since a supply of the first gas is started, the valve 314 may be closed to stop the supply of the first gas. In other words, even after a predetermined time has elapsed since a supply of the second gas is started, the second gas is being supplied, and the supply of the first gas may be stopped while the second gas is being supplied. For example, the supply of the first gas and the supply of the second gas may be stopped at the same time (that is, simultaneously). In addition, the supply of the first gas may be stopped after the supply of the second gas is stopped.

In such an operation, for example, the APC valve 243 is appropriately adjusted such that the inner pressure of the process chamber 201 can be set to a pressure within a range from 1 Pa to 3,990 Pa. For example, a time duration during which the second gas is supplied to the wafer 200 while stopping the supply of the first gas can be set to a time duration within a range from 0.1 second to 30 seconds.

In such a time duration mentioned above, the second gas is supplied to the wafer 200.

In a manner described above, by stopping the supply of the first gas while the second gas is being supplied and then stopping the supply of the second gas after a predetermined time has elapsed since the supply of the first gas is stopped, it is possible to reduce (or decrease) an amount of the by-products remaining in the process chamber 201, and it is also possible to improve a quality of a first element-containing film such as a titanium nitride film (TiN film).

By supplying the second gas, it is possible to increase the number of adsorption sites on the wafer 200 where the source material can be adsorbed. On the other hand, molecules of the second gas present on the wafer 200 or in the process chamber 201 may inhibit molecules of the first gas from adsorbing onto the wafer 200. In particular, after the by-products on the wafers 200 or in the process chamber 201 are decreased to a certain extent, it is possible to significantly suppress an adsorption of the molecules of the first gas by the molecules of the second gas.

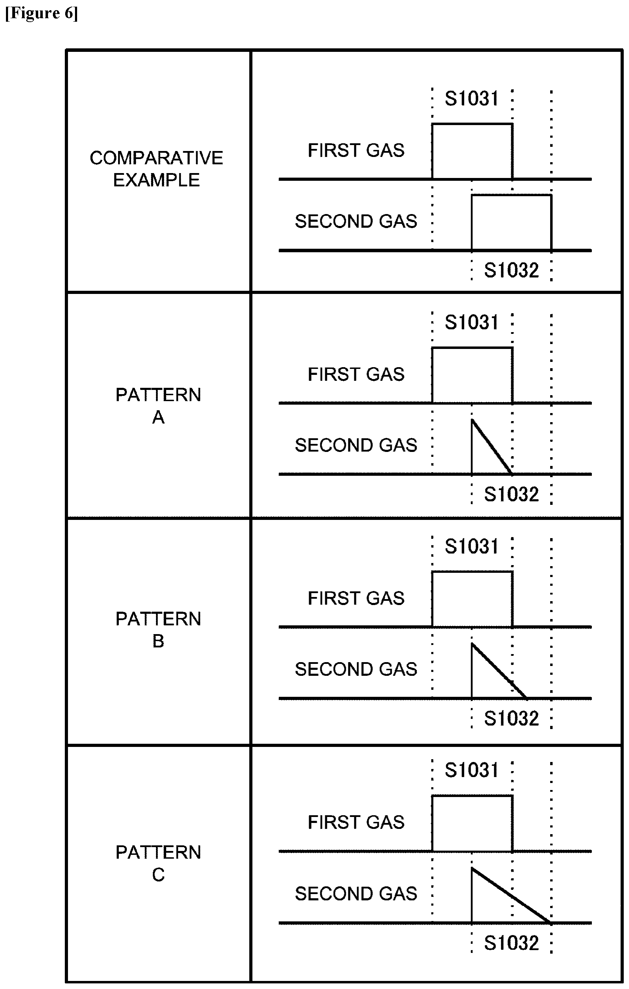

As a method of suppressing the adsorption of the molecules of the first gas by the molecules of the second gas, for example, patterns (that is, gas supply patterns) A to N shown in FIGS. 6 to 9 may be used.

### <Pattern A>

The pattern A is a pattern in which a supply amount of the second gas is decreased from the time the supply of the second gas is started. By supplying the second gas in such a manner, it is possible to remove the by-products by the second gas as described above, and after the by-products are decreased to a certain extent, it is also possible to reduce (decrease) the molecules of the second gas. As a result, when the supply of the second gas is started, it is possible to suppress an inhibition of the adsorption of the first gas by the by-products. In addition, by reducing the supply flow rate (partial pressure) of the second gas, it is possible to suppress the inhibition of the adsorption of the first gas by the molecules of the second gas. In addition, in the pattern A, there is provided a sequence in which a timing of an end of the supply of the second gas is synchronized with a timing of an end of the supply of the first gas. With such a configuration, a partial pressure of the first gas in the process chamber 201 increases, especially towards the end of the supply of the second gas. Thereby, it is possible to improve a probability that the molecules of the first gas can adsorb to the wafer 200.

In the present specification, the supply amount of the gas in the present disclosure is adjusted by at least one among the supply flow rate and a supply time (time duration) of the gas related thereto set in each MFC. In addition, the supply amount of the gas may be considered in terms of a concentration or a partial pressure of the gas. Therefore, for example, "reducing (decreasing) the supply amount of the gas" may mean that "reducing (decreasing) the supply flow rate of the gas" over time.

### <Pattern B>

The pattern B is a pattern in which the supply of the second gas is terminated after the supply of the first gas is terminated. With such a configuration, it is possible to promote an evacuation (exhaust) of the by-products generated immediately before the end of the supply of the first gas from the process chamber 201.

### <Pattern C>

The pattern C is a pattern in which the timing of the end of the supply of the second gas is delayed compared to the pattern B.

It can be said that, in the patterns A to C, a reduction rate (reduction speed) in the supply amount of the second gas can be changed between the patterns, for example, A to C. The reduction rate in the supply amount of the second gas may be changed based on the process temperature. By a reaction of the second gas, a constituent in a material of the second gas may be enter (incorporated into) the film. In the present embodiments, for example, the term "constituent" may refer to the predetermined element contained in the material of the second gas. When the constituent is incorporated into the film, the film may not be provided with desired properties. For example, when the film is conductive, electrical properties of the film may deteriorate. A reaction amount of the second gas may depend on the process temperature. For example, when the process temperature is higher than a predetermined temperature, the reaction amount may increase. On the other hand, when the process temperature is lower than the predetermined temperature, the reaction amount may decrease. When the reaction amount increases, a larger amount of the constituent of the second gas may be incorporated into the film. Therefore, when it is preferable to prevent the constituent of the second gas from being incorporated into the film, the supply amount of the second gas can be reduced. However, when simply reducing the supply amount of the second gas, an amount of the adsorption inhibitor removed as described above may also be reduced. As a result, an amount of the molecules of the first gas adsorbed onto the wafer 200 may also be reduced. To address such a problem, as disclosed herein, in the time duration during which the second gas alone is supplied, the second gas may be reduced from immediately after a start of the supply of the second gas to an end of the supply of the second gas. By reducing the second gas in a manner described above, it is possible to reduce the supply amount of the second gas in an entirety of the time duration during which the second gas alone is supplied suppressing a decrease in the amount of the adsorption inhibitor removed as described above. For example, in the time duration during which the second gas alone is supplied, the supply flow rate of the second gas may be increased from the start of supply to the end of the supply of the second gas. However, from the perspective of efficiently removing the adsorption inhibitor, it is preferable to supply the gas (for example, the second gas) in the patterns shown in the drawings of the present disclosure. This is because more adsorption inhibitors are generated at a start of the supply of the first gas in the time duration during which the first gas is supplied. In addition, by changing the reduction rate in the supply amount of the second gas, a supply time of the second gas also is changed. As a result, a stagnation time of the second gas in the process chamber 201 also is changed. By changing the stagnation time of the second gas in the process chamber 201, the reaction amount of the second gas may be changed. By shortening the stagnation time of the second gas, the reaction amount of the second gas may be reduced.

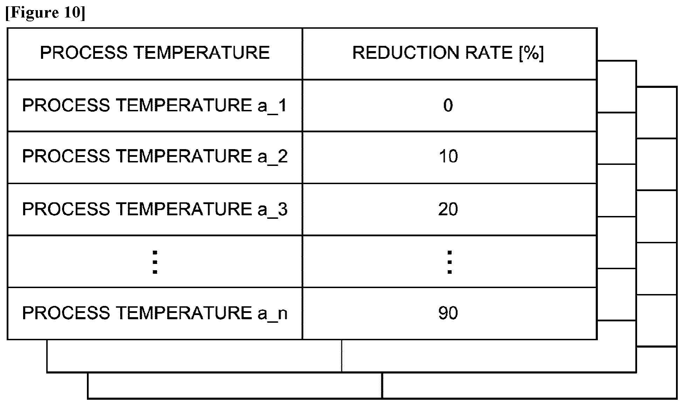

The reduction rate in the supply amount of the second gas may be set based on the process temperature of the wafer 200. For example, table data such as that shown in FIG. 10 is prepared, and the reduction rate corresponding to the process temperature (which is set in advance) is read from the table data to set the reduction rate of the second gas. In FIG. 10, process temperatures a_1, a_2, a_3, ..., a_n may indicate that the process temperatures are set to increase in this order. The reduction rate of the second gas increases as the process temperature increases. As shown in FIG. 10, for example, the reduction rate may be set to a rate between 10 % and 90 %. When the process temperature is higher than a predetermined temperature, data with a larger reduction rate is read from the table data to set the reduction rate of the second gas. For example, as in the pattern A, the reduction rate (that is, a gradient at which the supply of the second gas decreases) from the start of the supply of the second gas to the end of the supply of the second gas can be increased. By configuring the supply of the second gas in a manner described above, it is possible to prevent products generated by a decomposition of the second gas from being incorporated into the film. In addition, it is also possible to obtain substantially the same effects as in the pattern A mentioned above. On the other hand, when the process temperature is lower than the predetermined temperature, the reduction rate is set to be smaller. For example, the second gas may be supplied as in the pattern C. While the present embodiments are described by way of an example in which the reduction rate is set as mentioned above, the present embodiments are not limited thereto. For example, the supply time of the second gas may also be adjusted. For example, the program recipe may also be configured such that the supply flow rate (partial pressure) of the second gas becomes zero in a time duration between an initial supply flow rate (partial pressure) and the supply time set as described above.

### <Pattern D>

The pattern D is an example of a pattern in which the supply amounts of the first gas and the second gas are changed relatively. By increasing the supply rate of the first gas, the supply rate (partial pressure) of the second gas can be relatively reduced. In such a case, the supply rate of the second gas may be maintained constant. As described above, the molecules of the second gas prevent the molecules of the first gas from reaching the wafer 200. Therefore, by increasing the number of the molecules of the first gas present on the wafer 200 or in the process chamber 201, it is possible to increase the number of the molecules of the first gas reaching the wafer 200. In addition, it is considered that the molecules of the first gas themselves also have an effect of pushing away the molecules of the second gas. However, since a generation amount of the by-products may also be increased by increasing the supply amount of the first gas, it is preferable to gradually increase the supply amount of the first gas, as shown in the pattern D.

### <Pattern E>

The pattern E is a pattern in which the supply amount of the first gas is increased while the supply amount of the second gas is decreased as in the patterns A to C.

### <Pattern F>

The patterns D and E are patterns in which the supply amount of the first gas is increased gradually immediately after a start of the supply of the first gas. When the first gas is supplied in such a manner, the generation amount of the by-products may also be increased. The pattern F is a pattern capable of addressing such a concern. In the pattern F, the supply of the first gas is increased gradually immediately after the start of the supply of the second gas. With such a configuration, it is possible to reduce the amount (generation mount) of the by-products generated by the supply of the first gas compared to the patterns D and E.

For example, as shown in the pattern F, it is preferable to start increasing the supply rate of the first gas after the supply of the second gas is started. This is because, when the supply rate of the first gas is increased immediately after the supply of the first gas is started, the amount (generation mount) of the adsorption inhibitors generated by the supply of the first gas may increase. Therefore, it is preferable to increase the supply rate of the first gas after the supply of the second gas is started.

### <Pattern G>

As a sequence of further reducing (decreasing) the amount of the by-products generated by the supply of the first gas, the pattern G is provided. The pattern G is a pattern in which the supply amount of the first gas is increased gradually from approximately zero. With such a configuration, it is possible to reduce the amount (generation mount) of the by-products generated by the supply of the first gas. For example, the supply amount of the first gas at the start of the supply of the first gas may be a small amount rather than zero. In the present specification, the term "small amount" may refer to a flow rate within a range from approximately 0.1 slm to 1 slm, for example.

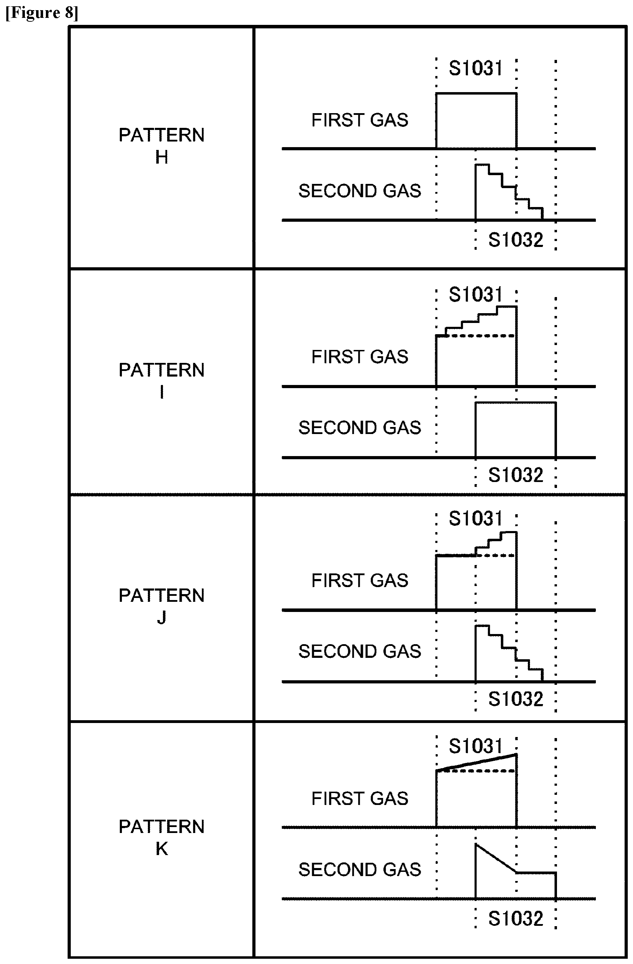

As described above, the present embodiments are described by way of an example in which the supply amount of the first gas is increased continuously or the supply amount of the second gas is decreased continuously. However, a method of increasing the supply amount of the first gas or a method of decreasing the supply amount of the second gas may not be limited to thereto. For example, as shown in the patterns H, I and J in FIG. 8, the supply amount of the first gas or the supply amount of the second gas may be changed in a step-wise manner. Even when changing the supply amount in the step-wise manner, it is possible to obtain substantially the same effects as in the patterns mentioned above. Preferably, the supply amount of the first gas or the supply amount of the second gas may be changed continuously. By using such a continuous change, it possible to suppress an abrupt change in the reaction that occurs on the wafer 200. As a result, it is possible to improve a uniformity of the titanium-containing layer (which is formed on the wafer 200) within the surface of the wafer 200.

In addition, in the pattern J, as in the pattern F, it is preferable to start increasing the supply rate of the first gas after the supply of the second gas is started.

### <Pattern K>

The pattern K is a pattern in which the supply amount of the second gas is decreased and the supply amount of the second gas is maintained constant after the supply of the first gas is terminated. After the supply of the first gas, it is possible to maintain the effect of removing the by-products present on the wafer 200 or in the process chamber 201.

### <Pattern L>

The pattern L is a pattern in which the reduction rate in the supply amount of the second gas is changed during the second gas is supplied. As an example of a change in the reduction rate, the reduction rate in the supply amount of the second gas is increased during the second gas is supplied. For example, the reduction rate may be increased after the supply of the first gas is completed (ended). After the supply of the first gas is completed, the amount (generation amount) of the adsorption inhibitors may decrease. Therefore, the supply amount of the second gas used to remove the adsorption inhibitor may be reduced. By increasing the reduction rate, it is possible to reduce the supply amount of the second gas.

### <Pattern M>

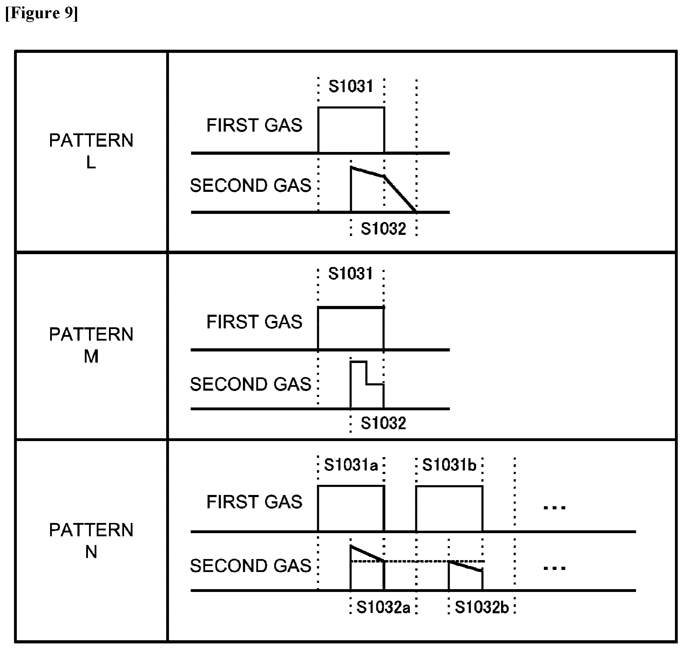

The pattern M is a pattern in which the supply amount of the second gas is reduced in fewer stages (steps) than other patterns such as the pattern H. According to the pattern M shown in FIG. 9, the second gas is supplied at two different supply amounts. Even when supplying the second gas in such a manner, it is possible to obtain similar effects as in the patterns mentioned above.

### <Pattern N>

The pattern N is a pattern that can be obtained when the first gas supply step S1031 and the second gas supply step S1032 are performed a plurality of times in succession. A first execution of the first gas supply step S1031 is indicated as "S1031a", and a first execution of the second gas supply step S1032 is indicated as "S1032a". Similarly, a second execution of the first gas supply step S1031 is indicated as "S1031b", and a second execution of the second gas supply step S1032 is indicated as "S1032b". As shown in FIG. 9, in the second execution S1032b of the second gas supply step S1032, the second gas is supplied at a smaller supply rate than in the first execution S1032a of the second gas supply step S1032. Therefore, the amount of the by-products (adsorption inhibitors) generated in the second execution S1031b (and its subsequent execution) of the first gas supply step S1031 is smaller than the amount of the by-products generated in the first execution S1031a of the first gas supply step S103 1. As a result, in the second execution S1032b (and its subsequent execution) of the second gas supply step S1032, the amount of the second gas to be supplied is smaller than that of the second gas in the first execution S1032a of the second gas supply step S1032. By supplying a smaller amount of the second gas from the second execution S1032b (and its subsequent execution) than that of a previous execution thereof, it is possible to reduce the inhibition of the adsorption of the first gas due to a presence of the second gas, and it is also possible to increase the amount of the adsorption of the first gas. Further, from the second execution S1032b (and its subsequent execution), it is possible to reduce an amount of constituents of the second gas being incorporated into the layer formed in such an execution. It is preferable that the flow rate (partial pressure) during such a gas supply in the second gas supply step S1032 from the second execution S1032b (and its subsequent execution) is set to be substantially the same as the flow rate (partial pressure) at an end of the first execution S1032a (and its subsequent execution). With such a configuration, it is possible to prevent insufficient removal of the adsorption inhibitors.

### <Inert Gas Supply Step (Purging): S1033>

After a predetermined time has elapsed since the supply of the second gas is started, the valve 324 is closed to stop the supply of the second gas. In the present step, the valves 514, 524 and 534 are opened to supply the inert gas into the gas supply pipes 510, 520 and 530 (purging). That is, the inert gas is supplied into the process chamber 201.

In the present step, for example, the APC valve 243 is appropriately adjusted such that the inner pressure of the process chamber 201 can be set to a pressure within a range from 1 Pa to 3,990 Pa. For example, a supply flow rate of the inert gas controlled by each of the MFC 512, 522 and 532 can be set to a flow rate within a range from 0.1 slm to 30 slm.

### <Exhaust Step>

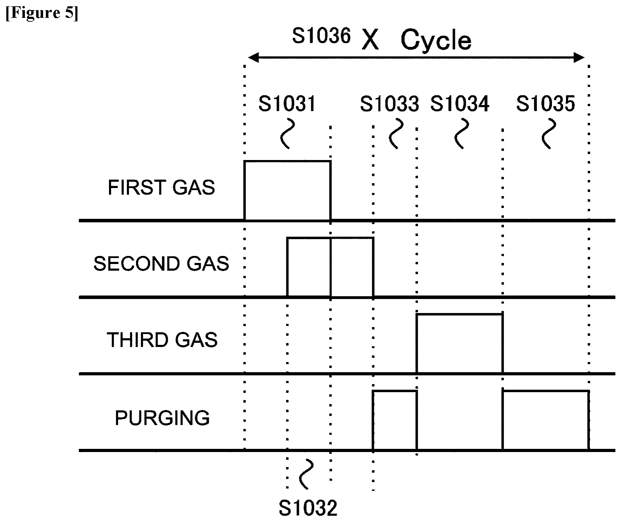

After a predetermined time has elapsed since a supply of the inert gas is started, the valves 514, 524 and 534 are closed to stop the supply of the inert gas. Although not shown in FIG. 5, in the present step, with the APC valve 243 of the exhaust pipe 231 open, the pump 246 vacuum-exhausts the inner atmosphere of the process chamber 201. Thereby, it is possible to remove a residual gas from above the wafer 200. That is, it is possible to remove (or exhaust) a substance such as reaction by-products and the residual gas remaining in the process chamber 201 from the process chamber 201. In the present step, for example, a time duration during which the inner atmosphere of the process chamber 201 is vacuum-exhausted can be set to a time duration within a range from 0.1 second to 30 seconds.

### <Third Gas Supply Step: S1034>

Subsequently, the valve 334 is opened to supply the third gas into the gas supply pipe 330. After a flow rate of the third gas is adjusted by the MFC 332, the third gas whose flow rate is adjusted is supplied into the process chamber 201 through the gas supply holes 430a of the nozzle 430, and is exhausted through the exhaust pipe 231.

In the present step, for example, the APC valve 243 is appropriately adjusted such that the inner pressure of the process chamber 201 can be set to a pressure within a range from 1 Pa to 3,990 Pa. For example, a supply flow rate of the third gas (second reactant) controlled by the MFC 332 can be set to a flow rate within a range from 0.1 slm to 30 slm. For example, a time duration during which the third gas is supplied to the wafer 200 can be set to a time duration within a range from 0.01 second to 30 seconds.

In the present step, the third gas is supplied to the wafer 200. In the present embodiments, as the third gas, a reacting agent may be used. As the reacting agent serving as the third gas, for example, a nitriding agent may be used. The nitriding agent is a gas containing nitrogen (N). Specifically, as the nitriding agent, a gas containing nitrogen and hydrogen (such as NH₃, N₂H₂ and N₂H₄) may be used. That is, such a reducing gas may be used as the third gas. The third gas is different from the second gas, and may also be referred to as a "second reducing gas". Hereinafter, the present embodiments will be described by way of an example in which NH₃ gas is used as the second reactant. When the NH₃ gas is supplied, a substitution reaction occurs between the NH₃ gas and at least a part of the titanium-containing layer formed on the wafer 200. During the substitution reaction, titanium contained in the titanium-containing layer combines (bonds) with nitrogen contained in the NH₃ gas. Thereby, a titanium nitride layer (TiN layer) is formed on the wafer 200. Specifically, by reacting the NH₃ with the TiClₓ adsorbed on the wafer 200, it is possible to form the titanium nitride layer on the wafer 200. In addition, during the substitution reaction, reaction by-products such as the HCl, ammonium chloride (NH₄Cl) and H₂ are generated.

### <Inert Gas Supply Step: S1035>

After a predetermined time has elapsed since a supply of the third gas is started, the valve 334 is closed to stop the supply of the third gas. In the present step, the valves 514, 524 and 534 are opened to supply the inert gas into the gas supply pipes 510, 520 and 530. That is, the inert gas is supplied into the process chamber 201.

In the present step, for example, the APC valve 243 is appropriately adjusted such that the inner pressure of the process chamber 201 can be set to a pressure within a range from 1 Pa to 3,990 Pa. For example, a supply flow rate of the inert gas controlled by each of the MFC 512, 522 and 532 can be set to a flow rate within a range from 0.1 slm to 30 slm. For example, a time duration during which the inert gas is supplied to the wafer 200 can be set to a time duration within a range from 0.1 second to 30 seconds.

In the present step, the inert gas is supplied into the process chamber 201. Thereby, it is possible to reduce reaction by-products or the third gas (which remains unreacted or which contributed to the film formation) remaining in the process chamber 201.

### <Exhaust Step>

After a predetermined time has elapsed since a supply of the inert gas is started, the valves 514, 524 and 534 are closed to stop the supply of the inert gas. Although not shown in FIG. 5, in the present step, with the APC valve 243 of the exhaust pipe 231 open, the pump 246 exhausts the inner atmosphere of the process chamber 201. Thereby, it is possible to remove a residual gas from above the wafer 200. That is, it is possible to remove (or exhaust) a substance such as the reaction by-products and the third gas (which remains unreacted or which contributed to the film formation) from the process chamber 201. In the present step, for example, a time duration during which the inner atmosphere of the process chamber 201 is exhausted can be set to a time duration within a range from 0.1 second to 30 seconds.

### <Performing Predetermined Number of Times: S1036>

In the film forming step (that is, the substrate processing step S103), by performing a cycle (in which the steps S1031 to S1035 described above are sequentially performed in this order) a predetermined number of times (X times, X is an integer of 1 or more)), it is possible to form a film of a predetermined thickness on the wafer 200. According to the present embodiments, for example, a titanium nitride film (TiN film) is formed.

After a predetermined film is formed on the wafer 200 in a manner described above, a purging and returning to an atmospheric pressure step S104 and a wafer unloading step (substrate unloading step) S105 are performed.

### <Purging and Returning to Atmospheric Pressure Step: S104>

Then, the inert gas is supplied into the process chamber 201 through each of the gas supply pipes 510 to 530, and is exhausted through the exhaust pipe 231. The inert gas acts as a purge gas. Thereby, the inner atmosphere of the process chamber 201 is purged with the inert gas. As a result, the substance such as the residual gas remaining in the process chamber 201 and the reaction by-products remaining in the process chamber 201 can be removed from the process chamber 201. Thereafter, the inner atmosphere of the process chamber 201 is replaced with the inert gas, and the inner pressure of the process chamber 201 is returned to the normal pressure (atmospheric pressure).

### <Wafer Unloading Step (Substrate Unloading Step): S105>

Thereafter, the SC 219 is lowered by the BE 115 and the lower end of the outer tube 203 is opened. The boat 217 with the wafers 200 (which are processed) supported therein is unloaded out of the outer tube 203 through the lower end of the outer tube 203. Then, the wafers 200 (which are processed) are discharged (transferred) out of the boat 217.

### (3) Effects According to Present Embodiments

According to the present embodiments, it is possible to obtain one or more of the following effects (A) to (G).
(A) By supplying each gas as shown in the pattern A mentioned above, it is possible to promote the adsorption of the molecules of the first gas to the surface of the wafer 200.
(B) By supplying each gas as shown in the patterns B and C mentioned above, it is possible to promote the evacuation (exhaust) of the by-products by the second gas.
(C) By changing the reduction rate in the supply amount of the second gas based on the process temperature of the wafer 200, it is possible to suppress an incorporation of decomposition products of the second gas into the film.
(D) By increasing the supply amount of the first gas as shown in the patterns D to G, it is possible to promote the adsorption of the molecules of the first gas to the surface of the wafer 200.
(E) By maintaining the supply amount of the first gas constant and increasing the supply amount of the first gas after the start of the supply of the second gas as shown in the pattern F, it is possible to promote the adsorption of the molecules of the first gas to the surface of the wafer 200 while suppressing an increase in the reaction by-products generated by supplying the first gas.
(F) As in the pattern G, by supplying a small amount of the first gas at the start of the supply of the first gas and increasing the amount of the first gas over time, it is possible to reduce the amount of the reaction by-products generated immediately after the supply of the first gas is started.
(G) As in the pattern K, by maintaining the supply amount of the second gas constant after the supply of the first gas is terminated, it is possible to reduce the amount of the by-products present on the wafer 200 or in the process chamber 201.

That is, according to the present embodiments, it is possible to improve a film forming rate of the film.

### (4) Other Embodiments of Present Disclosure

The technique of the present disclosure is described in detail by way of the embodiments mentioned above. However, the technique of the present disclosure is not limited thereto. The technique of the present disclosure may be modified in various ways without departing from the scope thereof.

For example, the embodiments mentioned above are described by way of an example in which the nitriding agent is used as the third gas (second reactant). However, the technique of the present disclosure is not limited thereto. For example, when forming a film of a metal element rather than a nitride film on the substrate, a hydrogen-containing gas free of nitrogen may be used. As the hydrogen-containing gas free of nitrogen, for example, a gas such as H₂ gas and deuterium (D₂) gas may be used. For example, when forming an oxide film, an oxidizing agent may be used. As the oxidizing agent, for example, an oxygen-containing gas may be used. Specifically, as the oxygen-containing gas, for example, one or more among O₂, O₃, H₂O, a gaseous mixture of the H₂ and the O₂, H₂O₂ and N₂O may be used. In addition, as each of the nitriding agent, a reducing agent and the oxidizing agent, a gas related thereto obtained by activating at least one of the gases disclosed herein.

For example, the embodiments mentioned above are described by way of an example in which the silane-based gas is used as the second gas. However, the technique of the present disclosure is not limited thereto. As the second gas, for example, a halosilane-based gas containing a halogen element may also be used. Since the halosilane-based gas contains the halogen element, as compared with a case where the silane-based gas free of the halogen element is used, an effect of removing the adsorption inhibitor is weaker. However, since the halosilane-based gas contains hydrogen, it is possible to obtain similar effect.

For example, the embodiments mentioned above are described by way of an example in which the supply flow rate (partial pressure) of the second gas is decreased over time. However, when the constituent of the second gas is intentionally incorporated into the film, the supply flow rate (partial pressure) of the second gas may be configured to increase over time.

It is preferable that the process recipe (that is, a program defining parameters such as process procedures and process conditions of the substrate processing) used to form the film is prepared individually in accordance with contents of the substrate processing such as a type of the film to be formed, a composition ratio of the film, a quality of the film, a thickness of the film, the process procedures and the process conditions of the substrate processing. That is, it is preferable that a plurality of process recipes are prepared. Then, when starting the substrate processing, it is preferable that an appropriate process recipe is selected among the process recipes in accordance with the contents of the substrate processing. Specifically, it is preferable that the process recipes (program products) are stored (installed) in the memory 121c of the substrate processing apparatus 10 in advance via an electric communication line or the recording medium (that is, the external memory 123) on which the process recipes are recorded. Then, when starting the substrate processing, the CPU 121a of the substrate processing apparatus 10 preferably selects the appropriate process recipe among the process recipes stored in the memory 121c in accordance with the contents of the substrate processing. With such a configuration, various films of different types, different composition ratios, different qualities and different thicknesses can be formed with versatility and with a high reproducibility using a single substrate processing apparatus. In addition, since a burden on an operator such as inputting the process procedures and the process conditions can be reduced, the substrate processing can be started (performed) quickly while avoiding a misoperation of the substrate processing apparatus 10.

For example, the technique of the present disclosure may also be realized by changing an existing process recipe installed in the substrate processing apparatus 10. When changing the existing process recipe to a new process recipe, the process recipe according to the technique of the present disclosure may be installed into the substrate processing apparatus 10 via the electric communication line or the recording medium (that is, the external memory 123) on which the process recipes are recorded, or the existing process recipe may be changed to the new process recipe (that is, the process recipe according to the technique of the present disclosure) by operating the input/output device 122 of the substrate processing apparatus 10.

In addition, for example, the technique of the present disclosure may also be used in a structure such as a word line of a DRAM and a NAND type flash memory of a three-dimensional structure.

Then present invention may be summarized as follows: It is possible to improve a film forming rate. There is provided a technique that includes: (a) supplying a first gas containing a primary element constituting a film and a halogen element to a substrate; (b) supplying a first reducing gas containing hydrogen to the substrate; (c) supplying a second reducing gas containing hydrogen to the substrate, wherein a material of the second reducing gas is different from that of the first reducing gas; (d) performing (a) and (b) in parallel, wherein a supply amount of the first reducing gas is decreased compared to that of when a supply of the first reducing gas is started while performing (a) and (b) in parallel; and (e) performing (d) and (c) a predetermined number of times to form the film on the substrate.

For example, the embodiments and modified examples mentioned above are described by way of an example in which a batch type substrate processing apparatus capable of simultaneously processing a plurality of substrates is used to form the film. However, the technique of the present disclosure is not limited thereto. For example, the technique of the present disclosure may be preferably applied when a single wafer type substrate processing apparatus capable of processing one or several substrates at once is used to form the film. For example, the embodiments mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film.

For example, the embodiments mentioned above are described by way of an example in which the process sequence mentioned above is performed in the same process chamber of the same substrate processing apparatus (in-situ). However, the technique of the present disclosure is not limited thereto. For example, one step and another step of the process sequence mentioned above may be performed in different process chambers of different substrate processing apparatuses (ex-situ), or each may be performed in a different process chamber of the same substrate processing apparatus.

The process procedures and the process conditions of each process using the substrate processing apparatuses mentioned above may be substantially the same as those of the embodiments or the modified examples mentioned above. Even in such a case, it is possible to obtain substantially the same effects as in the embodiments or the modified examples mentioned above.

Further, the embodiments and the modified examples mentioned above may be appropriately combined. The process procedures and the process conditions of each combination thereof may be substantially the same as those of the embodiments or the modified examples mentioned above.

## Claims

1. A substrate processing method comprising:
(a) supplying a first gas containing a primary element constituting a film and a halogen element to a substrate;
(b) supplying a first reducing gas containing hydrogen to the substrate;
(c) supplying a second reducing gas containing hydrogen to the substrate, wherein a material of the second reducing gas is different from that of the first reducing gas;
(d) performing (a) and (b) in parallel, wherein a supply amount of the first reducing gas is decreased compared to that of when a supply of the first reducing gas is started while performing (a) and (b) in parallel; and
(e) performing (d) and (c) a predetermined number of times to form the film on the substrate.

2. The substrate processing method of claim 1, wherein the supply amount of the first reducing gas is decreased in (d) in a step-wise manner, or wherein the supply amount of the first reducing gas is decreased continuously in (d).

3. The substrate processing method of claim 1 and/or 2, wherein a reduction rate in the supply amount of the first reducing gas in (d) is adjusted based on a temperature of when performing (e).

4. The substrate processing method of claim 3, wherein the reduction rate is increased to be greater than a predetermined value when the temperature is higher than a predetermined temperature, or wherein the reduction rate is decreased to be less than the predetermined value when the temperature is lower than the predetermined temperature.

5. The substrate processing method of any one or more of claims 1 to 4, further comprising
(f) continuously supplying the first reducing gas after (d).

6. The substrate processing method of claim 5, wherein the supply amount of the first reducing gas is maintained constant in (f), or wherein the supply amount of the first reducing gas in (f) is decreased subsequent to (d).

7. The substrate processing method of any one or more of claims 1 to 6, wherein, in (d), the supply amount of the first reducing gas is decreased relative to a supply amount of the first gas.

8. The substrate processing method of claim 7, wherein, in (d), the supply amount of the first reducing gas is decreased relative to the supply amount of the first gas by increasing the supply amount of the first gas.

9. The substrate processing method of claim 8, wherein, in (d), the supply amount of the first gas is increased after the supply of the first reducing gas is started.

10. The substrate processing method of any one or more of claims 1 to 9, wherein a supply amount of the first gas is increased in (d).

11. The substrate processing method of any one or more of claims 8 to 10, wherein the supply amount of the first gas is increased in (d) in a step-wise manner, or wherein, in (d), the supply amount of the first gas is increased continuously.

12. The substrate processing method of any one or more of claims 1 to 11, further comprising
(g) performing (a) and (b) in parallel after (d) separately from (d), wherein, while (a) and (b) are performed in parallel in (g), a supply amount of the first reducing gas in (g) is decreased compared to the supply amount of the first reducing gas in (d).

13. A method of manufacturing a semiconductor device, comprising
the method of any one or more of claims 1 to 12.

14. A program that causes a substrate processing apparatus, by a computer, to perform:
(a) supplying a first gas containing a primary element constituting a film and a halogen element to a substrate;
(b) supplying a first reducing gas containing hydrogen to the substrate;
(c) supplying a second reducing gas containing hydrogen to the substrate, wherein a material of the second reducing gas is different from that of the first reducing gas;
(d) performing (a) and (b) in parallel, wherein a supply amount of the first reducing gas is decreased compared to that of when a supply of the first reducing gas is started while performing (a) and (b) in parallel; and
(e) performing (d) and (c) a predetermined number of times to form the film on the substrate.

15. A substrate processing apparatus comprising:
a first gas supplier configured to supply a first gas containing a primary element constituting a film and a halogen element to a substrate;
a second gas supplier configured to supply a first reducing gas containing hydrogen to the substrate;
a third gas supplier configured to supply a second reducing gas containing hydrogen to the substrate, wherein a material of the second reducing gas is different from that of the first reducing gas; and
a controller configured to be capable of controlling the first gas supplier, the second gas supplier and the third gas supplier to perform:
(a) supplying the first gas to the substrate;
(b) supplying the first reducing gas to the substrate;
(c) supplying the second reducing gas to the substrate;
(d) performing (a) and (b) in parallel, wherein a supply amount of the first reducing gas is decreased compared to that of when a supply of the first reducing gas is started while performing (a) and (b) in parallel; and
(e) performing (d) and (c) a predetermined number of times to form the film on the substrate.
